Europäisches Patentamt

European Patent Office

Office européen des brevets

(19)

(11) Veröffentlichungsnummer: **0 090 904**
**B1**

(12) # EUROPÄISCHE PATENTSCHRIFT

(45) Veröffentlichungstag der Patentschrift:
**21.08.85**

(21) Anmeldenummer: **82710020.7**

(22) Anmeldetag: **03.04.82**

(51) Int. Cl.⁴: **H 03 H 17/02**

(54) Schaltungsanordnung für seriell arbeitende Digitalfilter.

(43) Veröffentlichungstag der Anmeldung:
**12.10.83 Patentblatt 83/41**

(45) Bekanntmachung des Hinweises auf die Patenterteilung:
**21.08.85 Patentblatt 85/34**

(84) Benannte Vertragsstaaten:
**DE FR GB IT NL**

(56) Entgegenhaltungen:
**FR - A - 2 244 206**

**ELECTRONIC ENGINEERING, Band 51, Nr. 618, Februar 1979, Seiten 69-78, London, G.B.G. EDWARDS: "Unravelling the digital filter tangle"**

(73) Patentinhaber: **Deutsche ITT Industries GmbH, Hans-Bunte-Strasse 19 Postfach 840, D-7800 Freiburg (DE)**

(84) Benannte Vertragsstaaten: **DE**

(73) Patentinhaber: **ITT INDUSTRIES INC., 320 Park Avenue, New York, NY 10022 (US)**

(84) Benannte Vertragsstaaten: **FR GB IT NL**

(72) Erfinder: **Backes, Reiner, Dipl.-Ing., Am Märzengraben 2, D-7800 Freiburg-Tiengen (DE)**

(74) Vertreter: **Stutzer, Gerhard, Dr. et al, Deutsche ITT Industries GmbH Patent- und Lizenzabteilung Hans-Bunte-Strasse 19 Postfach 840, D-7800 Freiburg (DE)**

## Beschreibung

Die Erfindung betrifft eine Schaltungsanordnung für Digitalfilter, die im natürlichen Binärcode und in Zweierkomplement-Darstellung während kurzer Impulse eines Filterabtastsignals auftretende digitale Eingangsdaten seriell verarbeiten und die eingangsseitig einen Parallel-Serien-Wandler, ferner mindestens einen Addierer, mindestens ein Schieberegister als Zustandsspeicher, mindestens einen Multiplizierer, dem ein eingangsdaten-abhängiges Signal als Multiplikator und ein mindestens während der Multiplikation konstanter Faktor als Multiplikand zugeführt sind, und ausgangsseitig einen Serien-Parallel-Wandler enthalten; vgl. den Oberbegriff des Anspruchs 1.

In dem Buch von S. A. Azizi »Entwurf und Realisierung digitaler Filter«, München 1981, ist auf den Seiten 288/89 kurz darauf hingewiesen, daß bei der schaltungsmäßigen Realisierung von digitalen Filtern, dort als »Hardware-Realisierung« bezeichnet, der Serienbetrieb möglich ist und daß dann die einzelnen Teilschaltungen des Digitalfilters entsprechende Serienanordnungen sind, also Serienmultiplizierer und -addierer etc. Für diese Betriebsart ist ferner angegeben, daß zusätzlich zum Filterabtastsignal noch ein weiteres Tastsignal, der dort so bezeichnete »Bittakt« erforderlich ist, der je nach der Wortlänge der Zustandsgrößen und Koeffizienten sehr viel höher als der Worttakt sein kann.

Von diesem Stand der Technik geht die in den Ansprüchen bezeichnete Erfindung aus. Es liegt ihr die Aufgabe zugrunde, eine Grundschaltung für seriell arbeitende Digitalfilter anzugeben, deren Teilschaltungen je nach Filtertyp entsprechend kombinierbar sind und insbesondere mehrfach vorgesehen werden können. Eine Unteraufgabe der Erfindung besteht darin, für derartige Digitalfilter besonders günstige in Zweiphasen-Isolierschicht-Feldeffekttransistor-Verhältnistechnik integrierbare Grundschaltungen für die einzelnen Teilschaltungen des Digitalfilters anzugeben.

Ein Vorteil der Erfindung besteht darin, daß durch die Realisierung der Multiplizierfunktion in der beanspruchten Weise und durch den jeweils nur einstufig vorgesehenen Addierer bzw. Subtrahierer während der Signalverarbeitung keine Übertragsbildungszeiten entstehen, wie dies üblicherweise bei mehrstelligen Addierern, Subtrahierern und Multiplizierern der Fall ist. Die Verarbeitungsgeschwindigkeit der Digitalfilter nach der Erfindung ergibt sich vielmehr lediglich aus der Wortbreite der zu verarbeitenden digitalen Eingangsdaten und unter anderem der genauigkeitsbedingten Wortbreite des Ausgangssignals.

Die Erfindung wird nun anhand der Figuren der Zeichnung näher erläutert.

Fig. 1 zeigt in Form eines Blockschaltbilds ein Ausführungsbeispiel der erfindungsgemäßen Grundschaltung eines Digitalfilters.

Fig. 2 zeigt das Blockschaltbild eines aus dem der Fig. 1 abgeleiteten Ausführungsbeispiels mit Einstellbarkeit für zwei Filterzeitkonstanten.

Fig. 3 bis 8 zeigen jeweils teilweise schematisch das Schaltbild für die Zweiphasen-Verhältnistechnik-Realisierung der einzelnen Teilschaltungen der Fig. 1 und 2, und zwar

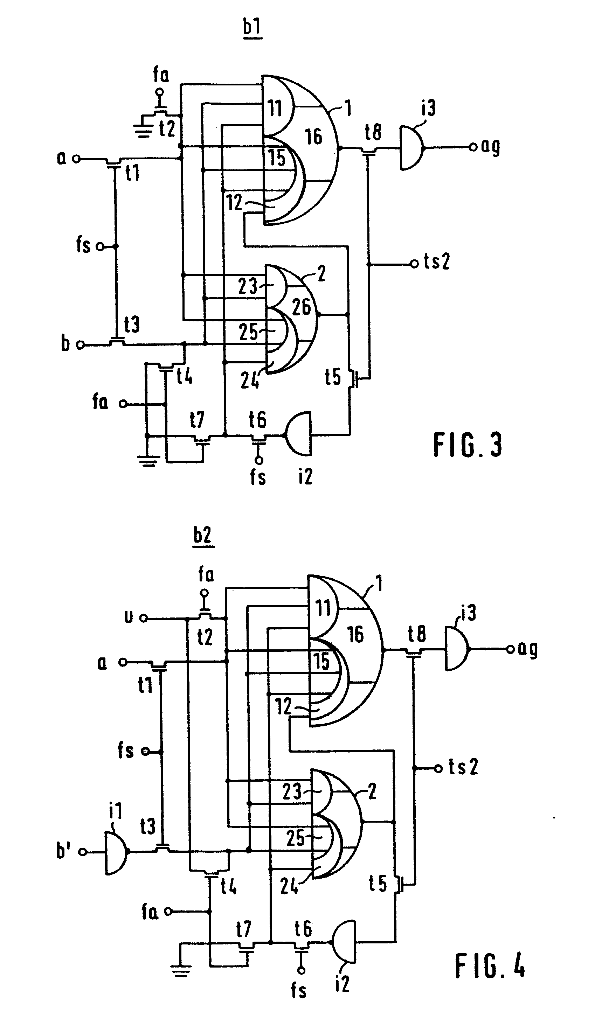

Fig. 3 für den Addierer,
Fig. 4 für den Subtrahierer,

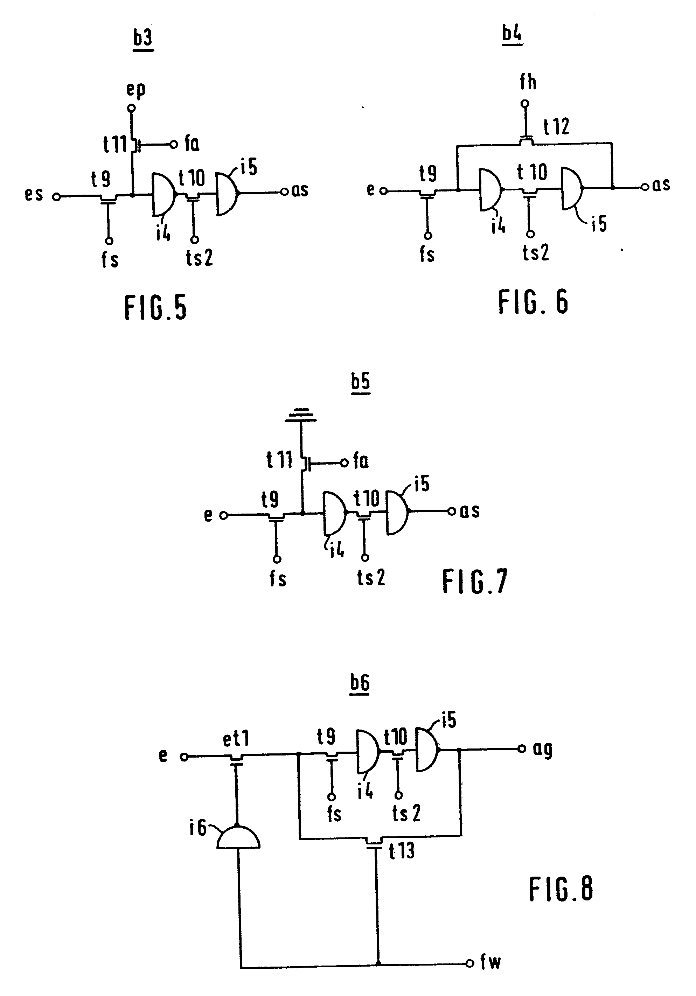

Fig. 5 für den Parallel-Serien-Wandler,
Fig. 6 für den Zustandsspeicher,
Fig. 7 für den Stellenergänzer und
Fig. 8 für den Vorzeichensignal-Wiederholer.

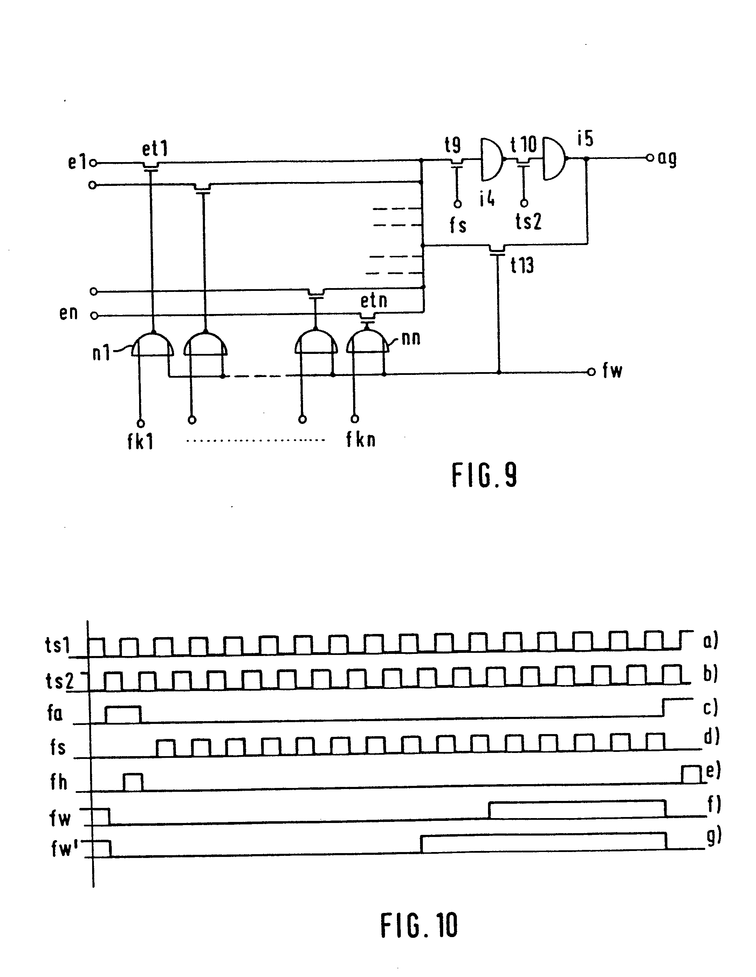

Fig. 9 zeigt das schematische Schaltbild eines Vorzeichen-Signal-Wiederholers mit zusätzlicher Wahlmöglichkeit für n Zeitkonstanten des Digitalfilters.

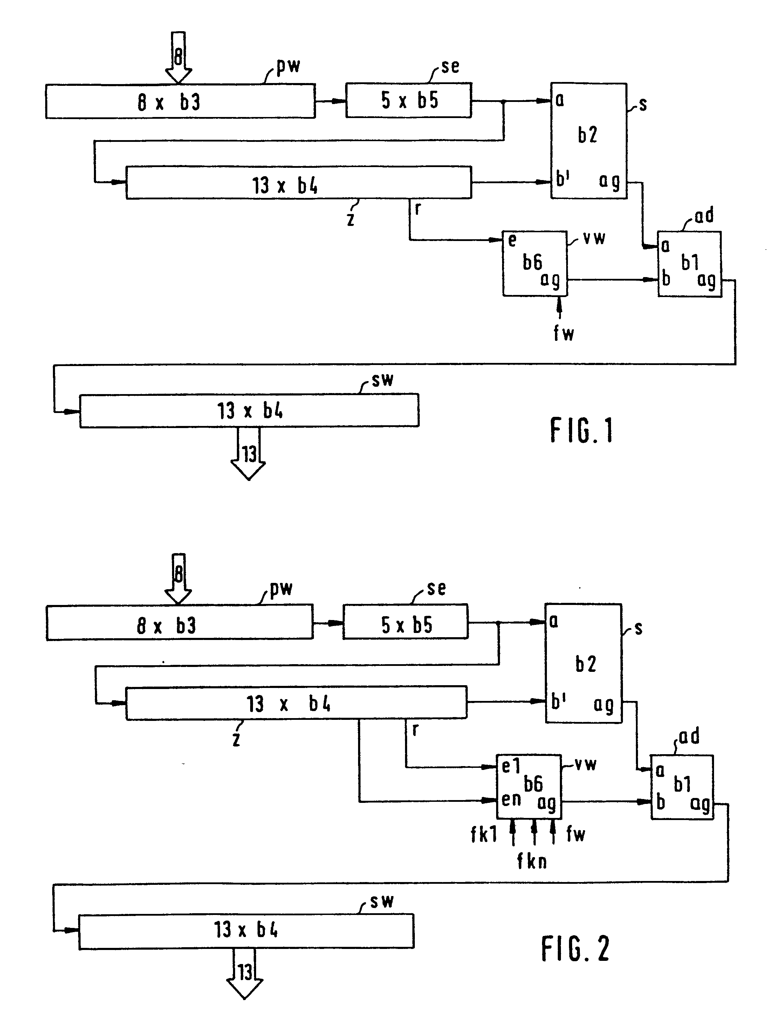

Fig. 10 zeigt Zeitdiagramme für die bei den Anordnungen nach den Fig. 1 bis 8 anzulegenden Taktsignale.

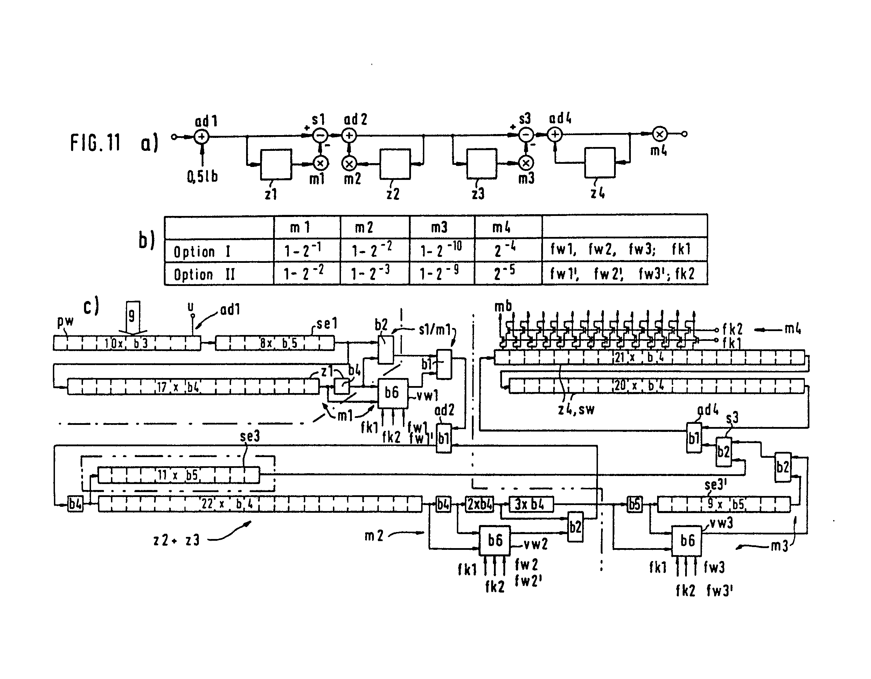

Fig. 11 zeigt als Ausführungsbeispiel ein Digitalfilter mit vier Zustandsspeichern und

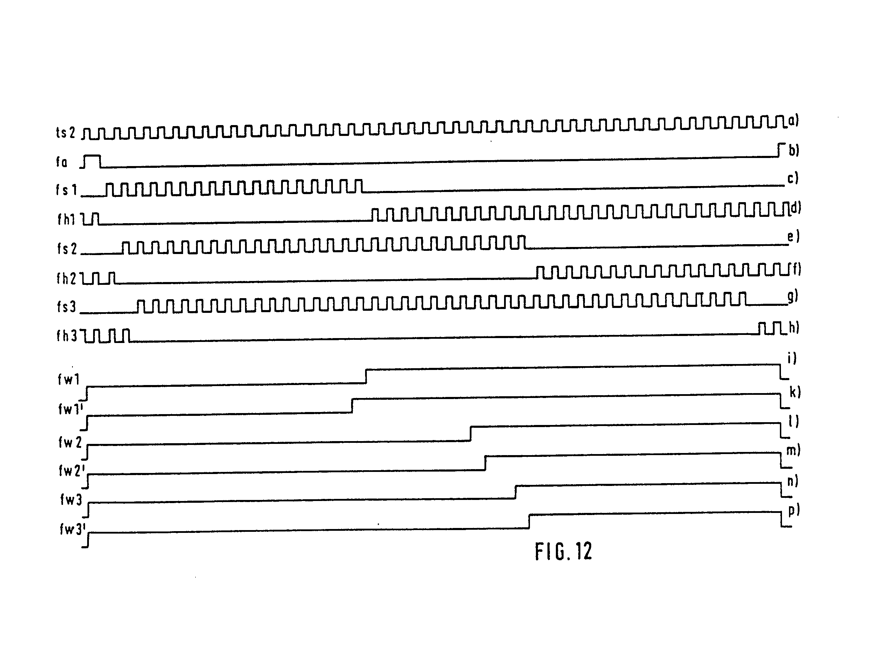

Fig. 12 zeigt die beim Ausführungsbeispiel nach Fig. 11 anzulegenden Taktsignale.

Das Ausführungsbeispiel nach Fig. 1 zeigt schematisch den Aufbau eines einfachen digitalen Hochpasses erster Ordnung, dem achtstellige digitale Eingangsdaten zugeführt sind. Diese können beispielsweise von einem entsprechenden Analog-Digital-Wandler stammen oder auch als Ausgangssignale von digitalen Signalprozessoren oder von entsprechenden Teilschaltungen auftreten. Die Erzeugung der digitalen Eingangsdaten des Digitalfilters liegt außerhalb des Rahmens der Erfindung.

Die Eingangsdaten werden im Takt des Filterabtastsignals fa (vgl. Fig. 10c) in den Parallel-Serien-Wandler pw übernommen, dessen Serienausgang mit dem Eingang des Stellenergänzers se verbunden ist. Dessen Ausgang liegt einerseits am Eingang des Zustandsspeichers z und andererseits am Minuendeingang a und dessen Ausgang am Subtrahendeingang b' des Subtrahierers s. Dessen Ausgang ag liegt am ersten Eingang a des Addierers ad.

Der Zustandsspeicher z hat zusätzlich zu der durch die Stellenzahl der Eingangsdaten vorgegebenen Stufenzahl, in Fig. 1 sind dies acht Stufen, weitere Stufen, deren Anzahl gleich der Stellenzahl des Multiplikanden ist. In Fig. 1 hat der Zustandsspeicher z somit dreizehn Stufen, woraus sich auch ergibt, daß der Stellenergänzer se fünf Stufen aufweisen muß. Der Eingang e des Vorzeichensignal-Wiederholers vw liegt am Ausgang einer der ausgangsnahen Stufen des Zustandsspeichers z, wobei bei Zählung vom Ausgang nach links die Nummer r dieser Stufe den Multiplikator in der Form $1-2^{-r}$ bestimmt. Der Ausgang ag des Vorzeichensignal-Wiederholers vw liegt am zweiten Eingang b des Addierers ad, dessen Ausgang ag seinerseits am Serieneingang des Serien-Parallel-Wandlers sw liegt. Dieser weist im Ausführungsbeispiel der Fig. 1 ebenfalls wie der Zustandsspeicher z dreizehn Stufen auf, da das Ausgangssignal dieses Digitalfilters dreizehn Stellen hat, die in paralleler Form am Parallel-Ausgang abgenommen werden können. Das Ausführungsbeispiel der Fig. 2 unterscheidet sich von dem der Fig. 1 lediglich darin, daß der Vorzeichensignal-Wiederholer vw nicht nur einen Eingang e wie in Fig. 1, sondern n Eingänge e1, en aufweist, die an weiteren Stufen des Zustandsspeichers z angeschlossen sind. Dadurch lassen sich durch entsprechende Umschaltung auf jeweils einen anderen der Eingänge en unterschiedliche Zeitkonstanten des Digitalfilters einstellen.

Je nach zu realisierendem Filtertyp ist es auch möglich, was jedoch in den Zeichnungen der Einfachheit halber nicht gezeigt ist, daß die Reihenfolge zwischen Subtrahierer s und Addierer ad vertauscht ist oder daß nicht nur jeweils ein Addierer ad vertauscht ist oder daß nicht nur jeweils ein Addierer oder Subtrahierer, sondern von beiden Arten mehrere innerhalb des Digitalfilters vorgesehen sind. An den Ausgang des signalflußmäßig letzten Addierers oder Subtrahierers braucht nicht unbedingt der Serienparallel-Wandler sw angeschlossen zu sein, sondern es kann, wie dies weiter unten anhand von Fig. 11 noch geschildert wird, ein weiterer Zustandsspeicher dort angeordnet sein.

Bei der Erfindung wird die Funktion des Multiplizierers nach dem Stand der Technik durch den Vorzeichensignal-Wiederholer vw in Verbindung mit den erwähnten Abgriffen an Stufen des Zustandsspeichers z realisiert. In diesem Zusammenhang ist darauf hinzuweisen, daß die erwähnte Art des Abgriffes an vor dem Ausgang liegenden Stufen des Zustandsspeichers z für Multiplikatoren gilt, die kleiner als eins sind. Solche Multiplikatoren treten im allgemeinen bei rekursiven Digitalfiltern auf, da bei derartigen Filtern Multiplikatoren, die größer als eins sind, zu Schwingungen führen würden. Bei nichtrekursiven Digitalfiltern dagegen können auch Multiplikatoren auftreten, die größer als eins sind. Dann weist der Multiplikator im allgemeinen links vom Komma und rechts vom Komma liegende Stellen auf, wobei die Rechtskommastellen wiederum zu Abgriffen entsprechend denen nach den Fig. 1 und 2, also in Richtung auf den Eingang des Zustandsspeichers z, führen, während die links vom Komma liegenden Stellen weitere Stufen des Zustandsspeichers z erfordern und zu entsprechenden Abgriffen an diesen weiteren Stufen führen.

In den Fig. 1 und 2 ist bei den entsprechenden Teilschaltungen die Anzahl der Stufen und die Art der Teilschaltung angegeben, wie sie in den Fig. 3 bis 8 im folgenden des näheren beschrieben werden. So besteht der Parallel-Serien-Wandler pw aus acht Stufen b3, der Stellenergänzer aus fünf Stufen b5 und der Zustandsspeicher z sowie der Serien-Parallel-Wandler sw aus je dreizehn Stufen b4. Ferner tragen in den Fig. 1 und 2 zur besseren Unterscheidung auch der Addierer ad, der Subtrahierer s und der Vorzeichensignal-Wiederholer vw entsprechende »Stufen«-Bezeichnungen, nämlich der Addierer ad kann als Stufe b1, der Subtrahierer s als Stufe b2 und der Vorzeichensignal-Wiederholer vw als Stufe b6 betrachtet werden.

In Fig. 3 ist teilweise schematisch das Schaltbild der Stufe b1, also des Addierers ad, gezeigt.

Für die Fig. 3 und 4 ist die Darstellung mittels der Schaltsymbole für Logikgatter so gewählt, daß nur solche Verknüpfungsglieder einen eigenen Arbeitswiderstand aufweisen, deren Ausgangsleitung am Berührungspunkt mit dem Halbkreis des Verknüpfungssymbols den zur Darstellung einer Invertierung üblichen Punkt haben. Es wird daher auch zwischen einem Gatter, das eine derartige Schaltung mit einem einzigen Arbeitswiderstand ist, und einer Verknüpfung als solcher unterschieden, die lediglich Teil eines Gatters ist und keinen gesonderten Arbeitswiderstand hat. Dies gilt für die Realisierung in Isolierschicht-Feldeffekttransistor-Technik, wie sie für die Fig. 3 und 4 vorausgesetzt ist.

Die Stufe b1 besteht aus dem ersten Komplexgatter 1 und dem zweiten Komplexgatter 2 sowie den noch zu erwähnenden weiteren Schaltungsteilen. Das erste Komplexgatter besteht aus der ersten UND-Verknüpfung 11 mit drei Eingängen, der ersten ODER-Verknüpfung 15 mit drei Eingängen, der zweiten UND-Verknüpfung 12 mit zwei Eingängen und der ersten NOR-Verknüpfung 16 mit zwei Eingängen. Der Ausgang der jeweiligen UND-Verknüpfung 11, 12 liegt dabei an jeweils einem Eingang der ersten NOR-Verknüpfung 16 und der Ausgang der ersten ODER-Verknüpfung 16 und der Ausgang der ersten ODER-Verknüpfung 15 am ersten Eingang der zweiten UND-Verknüpfung 12.

Das zweite Komplexgatter 2 besteht aus der dritten UND-Verknüpfung 23 mit zwei Eingängen, der zweiten ODER-Verknüpfung 25 mit zwei Eingängen, der vierten UND-Verknüpfung 24 mit zwei Eingängen und der zweiten NOR-Verknüpfung 26 mit zwei Eingängen. Der Ausgang der jeweiligen UND-Verknüpfung 23, 24 liegt an jeweils einem Eingang der zweiten NOR-Verknüpfung 26 und der Ausgang der zweiten ODER-Verknüpfung 25 am ersten Eingang der vierten UND-Verknüpfung 24.

Der jeweilige erste Eingang der ersten und der dritten UND-Verknüpfung 11, 23 sowie der ersten und der zweiten ODER-Verknüpfung 15, 25 liegt über die Schaltstrecke des ersten Transistors t1 am ersten Signaleingang a und über die Schaltstrecke des zweiten Transistors t2 am Schaltungsnullpunkt. Der jeweils zweite Eingang der ersten und der dritten UND-Verknüpfung 11, 23 sowie der ersten und der zweiten ODER-Verknüpfung 15, 25 liegt über die Schaltstrecke des dritten Transistors t3 am zweiten Signaleingang b und über die Schaltstrecke des vierten Transistors t4 am Schaltungsnullpunkt.

Der zweite Eingang der zweiten UND-Verknüpfung 12 liegt am Ausgang des zweiten Komplexgatters 2, der ferner in dieser Reihenfolge über die Schaltstrecke des fünften Transistors t5, den zweiten Inverter i2 und die Schaltstrecke des sechsten Transistors t6 am zweiten Eingang der vierten UND-Verknüpfung 24 und am jeweils dritten Eingang der ersten UND-Verknüpfung 11 und der ersten ODER-Verknüpfung 15 angeschlossen ist. Die letztgenannten drei Eingänge liegen ferner über die Schaltstrecke des siebten Transistors t7 am Schaltungsnullpunkt.

Der Ausgang des ersten Komplexgatters 1 liegt in dieser Reihenfolge über die Schaltstrecke des achten Transistors t8 und den dritten Inverter i3 am Ausgang ag des Addierers ad. Den Gates des fünften und des achten Transistors t5, t8 ist das zweite Zweiphasen-Taktsignal ts2, den Gates des zweiten, des vierten und des siebten Transistors t2, t4, t7 ist das Filterabtastsignal fa sowie den Gates des ersten, des dritten und des sechsten Transistors t1, t3, t6 das Datenschiebesignal fs zugeführt. Der zeitliche Verlauf dieser Signale ist in den Fig. 10b, c und d gezeigt, wobei die Fig. 10a den Verlauf des ersten Zweiphasen-Taktsignals ts1 veranschaulicht.

In diesem Zusammenhang wird darauf verwiesen, daß es sich bei den beiden Zweiphasen-Taktsignalen ts1, ts2 um rechteckförmige und gleichfrequente Signale handelt, die auf den Schaltungsnullpunkt bezogen sind, wobei die Amplitude des einen Signals in der Lücke zwischen den wirksamen Impulsen des anderen Taktsignals liegt und umgekehrt, d. h., die beiden Signale überlappen sich nicht. Im allgemeinen haben die beiden Signale ein Impuls-Pausen-Verhältnis von 1 : 1. Wie aus den Fig. 10a und d zu ersehen ist, ist das Datenschiebesignal fs gleichfrequent und gleichphasig mit dem ersten Zweiphasen-Taktsignal ts1, und es beginnt mit der ersten positiven Flanke des Signals ts1, die nach der negativen Flanke des Filterabtastsignals fa auftritt. Die Impulsbreite dieses Signals ist maximal gleich der Periodendauer der Taktsignale ts1, ts2, und seine Vorderflanke fällt mit einer der Vorderflanken des zweiten Taktsignals ts2 zusammen. Die Impulse des Datenschiebesignals fs treten bis zur Vorderflanke des nächsten Filterabtastsignal-Impulses auf.

Die Fig. 4 zeigt teilweise schematisch das Schaltbild der Stufe b2, also des Subtrahierers s. Diese Schaltung ist bis auf wenige abweichende Einzelheiten mit der Addiererschaltung nach Fig. 3 identisch. Abweichend davon liegt das jeweilige Ende des zweiten und des vierten Transistors t2, t4 nicht wie bei Fig. 3 am Schaltungsnullpunkt, sondern an der Betriebsspannung u. Ferner ist der Schaltstrecke des dritten Transistors t3 der erste Inverter i1 vorgeschaltet, so daß der Subtrahend-Eingang b' nur über diesen Inverter i1 mit dem dritten Transistor t3 in Verbindung steht, während bei Fig. 3 der zweite Signaleingang b des Addierers ad direkt mit der Schaltstrecke des dritten Transistors t3 verbunden ist.

Die Fig. 5, 6 und 7 zeigen die Stufen b3, b4, b5, also eine Stufe des Parallel-Serienwandlers pw, des Zustandsspeichers z und des Serienparallel-Wandlers sw sowie des Stellenergänzers se. Diese drei Stufen sind hinsichtlich der zwischen Eingang e, es und Serienausgang as liegenden Reihenschaltung von Transistoren und Invertern identisch und unterscheiden sich lediglich hinsichtlich der weiteren Beschaltung. Die erwähnte Reihenschaltung besteht, vom Eingang e, es aus gesehen, aus der Schaltstrecke des neunten Transistors t9, dem vierten Inverter i4, der Schaltstrecke des zehnten Transistors t10 und dem fünften Inverter i5, welche Reihenschaltung eine dynamische Zweiphasen-Verhältnistechnik-Schieberegisterstufe darstellt, sie ist also eine Ein-Bit-Verzögerungsstufe.

Bei der Stufe b3 nach Fig. 5 liegt der Eingang des vierten Inverters i4 über die Schaltstrecke des elften Transistors t11 am Paralleleingang ep, über den das Signal der entsprechenden Stelle des Eingangsdatenworts im Takt des Filterabtastsignals fa in die Stufe übernommen wird; das Signal fa liegt dabei am Gate des elften Transistors t11. Am Gate des neunten Transistors t9 liegt das Datenschiebesignal fs und an dem des zehnten Transistors t10 das zweite Zweiphasen-Taktsignal ts2 (vgl. Fig. 10).

Die Stufe b4 nach Fig. 6 unterscheidet sich dadurch von der Stufe b3, daß vom Eingang des Inverters i4 die Schaltstrecke des zwölften Transistors t12 zum Serienausgang as und somit auch zum Ausgang des fünften Inverters i5 führt, wobei dem Gate des zwölften Transistors t12 das Datenhaltesignal fh zugeführt ist. Der Verlauf dieses Signals ist in Fig. 10e gezeigt. Es unterscheidet sich dadurch vom Datenschiebesignal fs nach Fig. 10d, daß Schiebe- und Haltefunktion zueinander invers sind. Aus Fig. 10e folgt ferner, daß das Datenhaltesignal fh nur während der Dauer des Filterabtastsignals fa auftritt. Dies gilt nur, wenn die fa-Periode durch einen Filterzyklus ganz ausgefüllt ist.

Die Stufe b5 nach Fig. 7 unterscheidet sich von der Stufe b3 nach Fig. 5 darin, daß der dortige Paralleleingang ep dauernd mit dem Schaltungsnullpunkt verbunden ist, und somit in diese Stufe b5 immer der niedrigere L-Pegel der beiden Binärsignalpegel H, L übernommen wird. In diesem Zusammenhang sei erwähnt, daß für die Ausführungsbeispiele der Fig. 3 bis 8 und 11 die Realisierung mittels Enhancement-n-Kanal-Transistoren vorausgesetzt ist, so daß die auftretenden Takt- und Datensignale der positiven Logik zugeordnet sind.

In der Schaltung der Stufe b6 nach Fig. 8 liegt zwischen dem Eingang e und dem Ausgang ag in dieser Reihenfolge die Schaltstrecke des ersten Eingangstransistors et1 und die auch in den Schaltungen nach den Fig. 5 bis 7 vorhandene Reihenschaltung der Schaltungsteile t9, i4, t10, i5, also eine Ein-Bit-Verzögerungsstufe.

Der Verbindungspunkt von Eingangstransistor et1 und neuntem Transistor t9 ist über die Schaltstrecke des dreizehnten Transistors t13 mit dem Ausgang ag und somit auch mit dem Ausgang des fünften Inverters i5 verbunden. Dem Gate dieses Transistors ist das Vorzeichenwiederhol-Signal fw zugeführt, das ferner über den sechsten Inverter i6 auch das Gate des Eingangstransistors et1 steuert. Das Vorzeichenwiederhol-Signal fw ist für das Ausführungsbeispiel der Fig. 1 in Fig. 10f gezeigt; es hat während solcher festen Impulse des Datenschiebesignals fs nach Fig. 10d einen H-Pegel, deren Anzahl gleich der vom Ende des Zustandsspeichers z aus gerechneten Anzahl Stufen bis zum mit dem Eingang des Vorzeichensignal-Wiederholers vw verbundenen Abgriff für Fig. 1 ist, vorausgesetzt, daß dieser Abgriff an der fünftletzten Stufe vorgesehen ist, so daß während der fünf letzten Impulse des Datenschiebesignals fs der erwähnte H-Pegel des Vorzeichenwiederhol-Signals fw auftritt.

Die Fig. 9 zeigt eine Erweiterung der Stufe b6 nach Fig. 8 für den Fall, daß das seriell arbeitende Digitalfilter nach der Erfindung hinsichtlich seiner Filtercharakteristik umschaltbar sein soll. Dann hat der Vorzeichensignal-Wiederholer vw die Eingänge e1 ... en und von jedem dieser Eingänge führt ein Eingangstransistor et1, etn zum neunten Transistor t9. Anstatt des sechsten Inverters i6 nach Fig. 8 ist jedes Gate der Eingangstransistoren et1, etn von einem NOR-Gatter n1, nn mit zwei Eingängen angesteuert, wobei dem ersten Eingang der NOR-Gatter das Vorzeichenwiederhol-Signal fw und dem jeweiligen Eingang der NOR-Gatter eines von n Filterkonstanten-Auswahlsignalen fk1, fkn zugeführt ist.

Wie bereits erwähnt zeigt die Fig. 2, daß der Vorzeichensignal-Wiederholer vw über zwei Eingänge mit zwei Abgriffen am Zustandsspeicher z liegt. In diesem Zusammenhang zeigt die Fig. 10g das dem zweiten Abgriff zugeordnete Vorzeichenwiederhol-Signal fw', dessen H-Pegel um zwei Datenschiebesignal-Taktperioden länger dauert als das Vorzeichenwiederhol-Signal fw nach Fig. 10f, da der zweite Abgriff um zwei Stufen nach links gegenüber dem ersten Abgriff r verschoben ist.

In Fig. 11 ist die Anwendung der der Erfindung zugrunde liegenden Prinzipien für ein mehrstufiges Digitalfilter gezeigt, bei dem insgesamt vier Zustandsspeicher z1, z2, z3, z4 vorgesehen sind, die mit den vier Multiplizierern m1, m2, m3, m4, den drei Addierern ad1, ad2, ad4 und den zwei Subtrahierern s1, s3 in der in Fig. 11a schematisch gezeigten Art und Weise zusammengeschaltet sind. Daraus ist ersichtlich, daß es sich bei den mit den Bezugsziffern 1 und 3 bezeichneten Teilfiltern um nichtrekursive, dagegen bei den mit den Bezugsziffern 2 und 4 bezeichneten Teilfiltern um rekursive Digitalfilter handelt. Mittels des Addierers ad1 wird zum Eingangssignal zunächst ein konstanter Wert addiert, der der Hälfte der niederstwertigen Stelle lb entspricht. In vergleichbarer Weise wird vor dem Filterausgang das Signal noch mit einem konstanten Faktor mittels des Multiplizierers m4 multipliziert.

Die Tabelle nach Fig. 11b gibt für die konkrete Schaltung nach Fig. 11c den Zahlenwert an, mit dem die Multiplizierer m1 ... m4 das jeweilige Signal multiplizieren. Es ist ohne weiteres ersichtlich, daß diese Multiplikatoren im vorliegenden Beispiel alle kleiner als eins sind. Ferner ist aus der Tabelle der Fig. 11b zu ersehen, daß das Filter nach den Fig. 11a und c auf mit Option I bzw. Option II bezeichnete Multiplikatoren-Sätze umschaltbar ist. Dabei sind den beiden Optionen die am Ende der Tabelle jeweils angegebenen speziellen Signale zugeordnet.

Für das schematische Schaltbild der Fig. 11c ist angenommen, daß die Eingangsdaten neunstellig sind (vgl. die Ziffer 9 im bandartigen Eingangspfeil), so daß der Parallel-Serien-Wandler pw in diesem Falle unter Berücksichtigung der 0,5-lb-Addierung zehn Stufen b3 enthält. Es wird vorausgesetzt, daß die Eingangsdaten mit der höchstwertigen Stelle mb so eingegeben werden, daß diese in die äußerste linke Stufe gelangt. Die erwähnte Addition von 0,5 lb geschieht dadurch, daß der Eingang der von links aus gezählten zehnten Stufe mit der Betriebsspannung u verbunden ist. Der Zustandsspeicher z1 hat achtzehn Stufen b4, so daß der Stellenergänzer se1 acht Stufen b5 aufweist. Der Multiplikator m1 hat bei Option I den Wert $1-2^{-1}$, so daß der Ausgang des Zustandsspeichers z1 direkt mit dem entsprechenden Eingang des Vorzeichensignal-Wiederholers vw1 verbunden ist. Der dem Multiplikator m1 von Option II mit dem Wert $1-2^{-2}$ zugeordnete Abgriff liegt eine Stufe b4 vor dem Ausgang des Zustandsspeichers z1. Der Multiplizierer m1 ist somit durch diese beiden Abgriffe realisiert.

Die Funktion des Subtrahierers s1 und ein Teil der Funktion des Multiplizierers m1 ist durch die spezielle Anordnung der Stufen b2 am Ausgang des Stellenergänzers se1, b1 am Ausgang dieser Stufe b2 und des Vorzeichensignal-Wiederholers vw1 realisiert. Der Addierer ad2 erhält somit das Ausgangssignal der eben erwähnten Stufe b1 zugeführt.

Die eben erwähnte spezielle Realisierung von s1, m1 ergibt sich daraus, daß die Subtraktion $-(1-2^{-r})$ als Addition $+(2^{-r}-1)$ ausgeführt wird.

Die beiden Zustandsspeicher z2, z3 sind in Fig. 11c in der zweituntersten Zeile als sämtlich aus Stufen b4 bestehend gezeigt. Es sind neunundzwanzig derartige Stufen vorgesehen. Durch den Vorzeichensignal-Wiederholer vw2 und die diesem über den Subtrahend-Eingang nachgeschaltete Stufe b2, deren Minuend-Eingang am Abgriff vor der drittletzten Stufe der Zustandsspeicher z2 + z3 liegt, ist der restliche Teil der Funktion des Multiplikators m2 realisiert. Der Ausgang der eben erwähnten Stufe b2 liegt am anderen Eingang des Addierers ad2.

Der Ausgang der ersten Stufe b4 des Zustandsspeichers z2 + z3 liegt am Eingang des Stellenergänzers se3, der elf Stufen b5 hat und dessen Ausgang am Subtrahend-Eingang des Subtrahierers s3 liegt. Dessen Minuend-Eingang liegt am Ausgang einer weiteren Subtrahierer-Stufe b2, die zusammen mit dem Vorzeichensignal-Wiederholer vw3 und den Abgriffen, mit denen dessen beide Eingänge verbunden sind, die Funktion des Multiplizierers m3 verwirklicht.

Hierzu ist auch der weitere Stellenergänzer se3' mit zehn Stufen b5 vorgesehen, wobei am Abgriff der ersten Stufe b5 der eine Eingang und vor dieser Stufe b5 und somit auch zum Ausgang des Zustandsspeichers z2 + z3 der zweite Abgriff des Vorzeichensignal-Wiederholers vw3 liegt. Der Ausgang des Stellenergänzers se3' liegt am Subtrahend-Eingang des erwähnten zusätzlichen Subtrahierers b2 und der Ausgang des Vorzeichensignal-Wiederholers vw3 an dessen Minuend-Eingang.

Der Ausgang des Subtrahierers s3 liegt am einen Eingang des Addierers ad4, dessen Ausgang am Eingang des Serien-Parallel-Wandlers sw liegt. Dieser hat insgesamt einundvierzig Stufen b4, und sein Serienausgang liegt am anderen Eingang des vierten Addierers ad4. Die Funktion des Multiplizierers m4 wird dadurch realisiert, daß mittels der eingezeichneten Transistoren an den vierzehn ersten Stufen das Signal abgegriffen wird. Die beiden Optionen I, II werden durch die gezeichnete Umschaltung der Ausgänge zwischen benachbarten Stufen mittels der weiteren gezeigten Transistoren vorgenommen.

Die zum Zustandsspeicher z1 gehörenden Schaltungsteile sind in Fig. 11c durch die strichpunktierte Linie von den übrigen Schaltungsteilen getrennt. Die links oberhalb der strichpunktierten Linie liegenden Schaltungsteile sind mit dem Datenschiebesignal fs1 und dem Datenhaltesignal fh1 nach den Fig. 12c und d getaktet.

In Fig. 11c sind ferner die rechts liegenden Schaltungsteile sowie der Stellenergänzer se3 durch die strich-doppelpunktierte Linie von den übrigen Schaltungsteilen getrennt, wodurch angezeigt sein soll, daß diese Schaltungsteile mit dem Datenschiebesignal fs3 und dem Datenhaltesignal fh3 nach den Fig. 12g und h getaktet sind.

In den Fig. 12i bis 12p sind ferner die Vorzeichenwiederhol-Signale fw1, fw1'; fw2, fw2'; fw3, fw3' gezeigt, die den drei Vorzeichensignal-Wiederholern vw1, vw2, vw3 zugeordnet sind. Die Fig. 12e und f zeigen schließlich das Datenschiebesignal fs2 und das Datenhaltesignal fh2, das zwischen der strichpunktierten und der strich-doppelpunktierten Linie liegenden Schaltungsteilen zugeführt ist.

Aus der zeitlichen Zuordnung der in Fig. 12 gezeigten verschiedenen Signale ist ersichtlich, daß die Datenhaltesignale fh1, fh2, fh3 auch außerhalb der Impulse des Filterabtastsignals fa H-Pegel aufweisen können; dies ergibt sich in jedem konkreten Einzelfall aus der speziell realisierten Filtercharakteristik und -Funktion.

Wie aus Fig. 11c zu ersehen ist, lassen sich mit den sechs Stufen b1 ... b6 nach den Fig. 3 bis 8 beliebige Digitalfilterschaltungen realisieren. Durch Anwendung dieser sechs Stufen ergibt sich somit auch beim Layout einer solchen integrierten Schaltung eine günstige Anordnung, die durch die fast identische Zellenstruktur der Stufen b3 bis b6 einerseits und andererseits der Stufen b1 und b2 ermöglicht wird. Wenn somit der Elektroniker den speziell zu realisierenden Filtertyp und auch dessen Charakteristiken zahlenmäßig anhand des eingangs genannten Buches festgelegt hat, so erhält er durch die Erfindung ein günstiges schaltungstechnisches Mittel an die Hand, wie er dann den errechneten Filtertyp konkret schaltungstechnisch realisieren kann.

Wie bereits oben kurz angedeutet, erfolgt die Realisierung in Isolierschicht-Feldeffekttransistor-Technik zweckmäßigerweise mittels Enhancement-n-Kanal-Transistoren, wobei die Inverter zweckmäßigerweise Depletion-Load-Inverter sind. Im Bedarfsfall können jedoch auch Enhancement-p-Kanal-Transistoren verwendet werden, wobei sich dann entsprechende Enhancement-Load-Transistoren zur Verwendung anbieten.

Zu Fig. 11c ist noch nachzutragen, daß die einundvierzig Stufen b4 für den Zustandsspeicher z4 zugleich auch die Stufen für den Serienparallel-Wandler sw sind.

**Patentansprüche**

1. Schaltungsanordnung für Digitalfilter, die im natürlichen Binärcode und in Zweierkomplement-Darstellung während kurzer Impulse eines Filterabtastsignals (fa) auftretende digitale Eingangsdaten seriell verarbeiten und die eingangsseitig einen Parallel-Serien-Wandler (pw), ferner mindestens einen Addierer (ad), mindestens ein Schieberegister als Zustandsspeicher (z), mindestens einen Multiplizierer (m1 ...), dem ein eingangsdatenabhängiges Signal als Multiplikator und ein mindestens während der Multiplikation konstanter Faktor als Multiplikand zugeführt sind, und ausgangsseitig einen Serien-Parallel-Wandler (sw) enthalten, gekennzeichnet durch folgende Merkmale:

— der Zustandsspeicher (z) hat zusätzlich zu der durch die Stellenzahl der Eingangsdaten vorgegebenen Stufenzahl weitere Stufen, deren Anzahl gleich der Stellenzahl des Multiplikanden ist,
— dem Parallel-Serien-Wandler (pw) ist ein Stellenergänzer (se) nachgeschaltet, der die Stellenzahl des Ausgangssignals des Parallel-Serien-Wandlers (pw) auf die Stellenzahl des Zustandsspeichers (z) erhöht,
— die Funktion des Multiplizierers (m1 ...) ist durch einen Vorzeichensignal-Wiederholer (vw) und einen mit dessen Eingang verbundenen entsprechenden Abgriff an mindestens einer Stufe (r) des Zustandsspeichers (z) realisiert, und
— je nach Filtertyp liegen
— —entweder die beiden Eingänge eines Subtrahierers (s) am Ausgang des Stellenergänzers (se) und am Serienausgang des Zustandsspeichers (z), die beiden Eingänge des Addierers (ad) am Ausgang des Vorzeichensignal-Wiederholers (vw) und am Ausgang des Subtrahierers (s) sowie der Ausgang des Addierers (ad) am Eingang des Serien-Parallel-Wandlers (sw) oder eines weiteren Zusatzspeichers (z2 . . .)

— —oder die beiden Eingänge des Addierers (ad) am Ausgang des Stellenergänzers (se) und am Serienausgang des Zustandsspeichers (z), die beiden Eingänge des Subtrahierers (s) am Ausgang des Vorzeichensignal-Wiederholers (vw) und am Ausgang des Addierers (ad) sowie der Ausgang des Subtrahierers (s) am Eingang des Serien-Parallel-Wandlers (sw) oder eines zweiten Zusatzspeichers (z2 . . .).

2. Schaltungsanordnung nach Anspruch 1, gekennzeichnet durch ihre integrierte Realisierung in dynamischer Zweiphasen-Feldeffekttransistor-Verhältnistechnik.

3. Schaltungsanordnung nach Anspruch 2 für den Addierer (ad) bzw. den Subtrahierer (s), gekennzeichnet durch folgende Merkmale:

— ein erstes Komplexgatter (1) besteht aus einer ersten UND-Verknüpfung (11) mit drei Eingängen, einer ersten ODER-Verknüpfung (15) mit drei Eingängen, einer zweiten UND-Verknüpfung (12) mit zwei Eingängen und einer ersten NOR-Verknüpfung (16) mit zwei Eingängen, wobei der Ausgang der jeweiligen UND-Verknüpfung (11, 12) an jeweils einem Eingang der ersten NOR-Verknüpfung (16) und der Ausgang der ersten ODER-Verknüpfung (15) am ersten Eingang der zweiten UND-Verknüpfung (12) liegt,

— ein zweites Komplexgatter (2) besteht aus einer dritten UND-Verknüpfung (23) mit zwei Eingängen, einer zweiten ODER-Verküpfung (25) mit zwei Eingängen, einer vierten UND-Verknüpfung (24) mit zwei Eingängen und einer zweiten NOR-Verknüpfung (26) mit zwei Eingängen, wobei der Ausgang der jeweiligen UND-Verknüpfung (23, 24) an jeweils einem Eingang der zweiten NOR-Verknüpfung (26) und der Ausgang der zweiten ODER-Verknüpfung (25) am ersten Eingang der vierten UND-Verknüpfung (24) liegt,

— der jeweilige erste Eingang der ersten und der dritten UND-Verknüpfung (11, 23) sowie der ersten und der zweiten ODER-Verknüpfung (15, 25) liegt über die Schaltstrecke eines ersten Transistors (t1) am ersten Signaleingang (a) und über die Schaltstrecke eines zweiten Transistors (t2) im Falle des Addierers (ad) am Schaltungsnullpunkt bzw. im Falle des Subtrahierers (s) an der Betriebsspannung (u),

— der jeweils zweite Eingang der ersten und der dritten UND-Verknüpfung (11, 23) sowie der ersten und der zweiten ODER-Verknüpfung (15, 25) liegt über die Schaltstrecke eines dritten Transistors (t3) im Falle des Addierers (ad) direkt am zweiten Signaleingang (b) bzw. im Falle des Subtrahierers (s) unter Zwischenschaltung eines ersten Inverters (i1) am Subtrahend-Eingang (b') und über die Schaltstrecke eines vierten Transistors (t4) im Falle des Addierers (ad) am Schaltungsnullpunkt bzw. im Falle des Subtrahierers (s) an der Betriebsspannung (u),

— der zweite Eingang der zweiten UND-Verknüpfung (12) liegt am Ausgang des zweiten Komplexgatters (2), der in dieser Reihenfolge über die Schaltstrecke eines fünften Transistors (t5), einen zweiten Inverter (i2) und die Schaltstrecke eines sechsten Transistors (t6) am zweiten Eingang der vierten UND-Verknüpfung (24) und am jeweils dritten Eingang der ersten UND-Verknüpfung (11) und der ersten ODER-Verknüpfung (15) angeschlossen ist, welche drei Eingänge über die Schaltstrecke eines siebten Transistors (t7) am Schaltungsnullpunkt liegen,

— der Ausgang des ersten Komplexgatters (1) liegt in dieser Reihenfolge über die Schaltstrecke eines achten Transistors (t8) und eines dritten Inverters (i3) am Ausgang (ag) des Addierers (ad) bzw. des Subtrahierers (s), und

— den Gates des fünften und des achten Transistors (t5, 58) ist das zweite Zweiphasen-Taktsignal (ts2), den Gates des zweiten, des vierten und des siebten Transistors (t2, t4, t7) ist das Filterabtast-Signal (fa) sowie den Gates des ersten, des dritten und des sechsten Transistors (t1, t3, t6) ein Datenschiebe-Signal (fs) zugeführt.

4. Schaltungsanordnung nach Anspruch 2 für eine Stufe des Parallel-Serien-Wandlers (pw) oder des Serien-Parallel-Wandlers (sw) bzw. des Stellenergänzers (se) bzw. des Zustandsspeichers (z), gekennzeichnet durch folgende Merkmale:

— es ist eine Ein-Bit-Verzögerungsstufe vorgesehen, bei der zwischen Serien-Eingang (e bzw. es) und -Ausgang (as) in dieser Reihenfolge die Schaltstrecke eines neunten Transistors (t9), ein vierter Inverter (i4), die Schaltstrecke eines zehnten Transistors (t10) und ein fünfter Inverter (i5) liegen,

— im Falle der Wandler (tw, sw) bzw. des Stellenergänzers (se) ist der Eingang des vierten Inverters (i4) über die Schaltstrecke eines elften Transistors (t11) am Paralleleingang (ep) der Wandler (pw, sw) bzw. am Schaltungsnullpunkt angeschlossen, bzw.

— im Falle des Zustandsspeichers (z) liegt der Eingang des vierten Inverters (i4) über die Schaltstrecke eines zwölften Transistors (t12) am Ausgang (ag), und

— das Gate des neunten Transistors (t9) liegt am Datenschiebesignal (fs), das Gate des zehnten Transistors (t10) am zweiten Zweiphasen-Taktsignal (ts2), das Gate des elften Transistors (t11) am Filterabtastsignal (fa) und das Gate des zwölften Transistors (t12) an einem Datenhaltesignal (fh).

5. Schaltungsanordnung nach Anspruch 2 für den Vorzeichensignal-Wiederholer (vw), gekennzeichnet durch folgende Merkmale:

— zwischen Eingang (e) und Ausgang (ag) liegen in dieser Reihenfolge die Schaltstrecke eines ersten Eingangstransistors (et1) und einer Ein-Bit-Verzögerungsstufe, bei der zwischen erstem Eingangstransistor (et1) und Serienausgang (as) in dieser Reihenfolge die Schaltstrecke eines neunten Transistors (t9), ein vierter Inverter (i4), die Schaltstrecke eines zehnten Transistors (t10) und ein fünfter Inverter (i5) liegen,
— der Verbindungspunkt von erstem Eingangstransistor (et1) und neuntem Transistor (t9) ist über die Schaltstrecke eines dreizehnten Transistors (t13) mit dem Ausgang (ag) verbunden,
— dem Gate des dreizehnten Transistors (t13) ist ein Vorzeichenwiederhol-Signal (fw) und dem Gate des ersten Eingangstransistor (et1) über einen sechsten Inverter (i6) dieses Signal zugeführt, und
— am Gate des neunten Transistors (t9) liegt das Datenschiebe-Signal (fs) und am Gate des zehnten Transistors (t10) das zweite Zweiphasen-Taktsignal (ts2).

6. Schaltungsanordnung nach Anspruch 5, gekennzeichnet durch folgende Merkmale:

— es sind weitere Eingangstransistoren (etn) vorgesehen, deren Schaltstrecken zwischen dem neunten Transistor (t9) und jeweils einem anderen Stufenausgang des Zusatzspeichers (z) angeordnet sind,
— der sechste Inverter (i6) ist durch ein erstes NOR-Gatter (n1) mit zwei Eingängen ersetzt,
— jeweils ein weiteres NOR-Gatter (nn) mit zwei Eingängen ist jedem weiteren Eingangstransistor (etn) zugeordnet, das dessen Gate ansteuert, und
— dem ersten Eingang der NOR-Gatter (n1 ... nn) ist das Vorzeichenwiederhol-Signal (fw) und dem jeweiligen zweiten Eingang der NOR-Gatter (n1 ... nn) eines von n Filterkonstanten-Auswahlsignalen (fk1 ... fkn) zugeführt.

## Claims

1. Circuit arrangement for digital filters by which digital input signals occurring in the pure binary code and in two's complement notation during short pulses of a filter sampling signal (fa) are processed in serial form, and which contain a parallel-to-serial converter (pw) at the input end, at least one adder (ad), at least one shift register used as a status register (z), at least one multiplier circuit (m1 ...) to which an input-data-dependent signal and a factor which is constant at least during the multiplication are applied as the multiplier and the multiplicand, respectively, and a serial-to-parallel converter (sw) at the output end, characterized by the following features:

—the status register (z) has, in addition to the number of stages determined by the number of digits of the input data, a number of stages equal to the number of digits of the multiplicand;
— the parallel-to-serial converter (pw) is followed by a digit complementer (se) which increases the number of digits of the output signal of the parallel-to-serial converter (pw) to the number of digits of the status register (z);
— the function of the multiplier circuit (m1 ...) is realized with a sign-signal repeater (vw) tap on at least one stage (r) of the status register (z) which tap is connected to the input of the sign-signal repeater (vw), and
— depending on the filter type,
— —either the two inputs of a subtracter (s) are connected to the output of the digit complementer (se) and to the serial output of the status register (z), the two inputs of the adder (ad) are connected to the sign-signal repeater (vw) and to the output of the subtracter (s), and the output of the adder (ad) is connected to the input of the serial-to-parallel converter (sw) or of an additional status register (z2 ...)
— —or the two inputs of the adder (ad) are connected to the output of the digit complementer (se) and to the serial output of the status register (z), the two inputs of the subtracter (s) are connected to the output of the sign-signal repeater (vw) and to the output of the adder (ad), and the output of the subtracter (s) is connected to the input of the serial-to-parallel converter (sw) or of an additional status register (z2 ...).

2. A circuit arrangement as claimed in claim 1, characterized by being implemented with ratiotype dynamic integrated field-effect transistor technology using a two-phase clock system.

3. A circuit arrangement as claimed in claim 2 for the adder (ad) or the subtracter (s), characterized by the following features:

— a first complex gate (1) consists of a first, three-input AND element (11), a first, three-input OR element (15), a second, two-input AND element (12), and a first, two-input NOR element (16), with the outputs of the AND elements (11, 12) each connected to one input of the first NOR element (16), and the output of the first OR element (15) connected to the first input of the second AND element (12);

— a second complex gate (2) consists of a third, two-input AND element (23), a second, two-input OR element (25), a fourth, two-input AND element (24), and a second, two-input NOR element (26), with the outputs of the AND elements (23, 24) each connected to one input of the second NOR element (26), and the output of the second OR element (25) connected to the first input of the fourth AND element (24),

— the first inputs of the first and third AND elements (11, 23) and of the first and second OR elements (15, 25) are connected through the channel of a first transistor (t1) to the first signal input (a), and through the channel of a second transistor (t2) to ground in the case of the adder (ad) or to the supply voltage (u) in the case of the subtracter (s);

— the second inputs of the first and third AND elements (11, 23) and of the first and second OR elements (15, 25) are connected to a second signal input (b) through the channel of a third transistor (t3) in the case of the adder (ad) or to the subtrahend input (b') through the channel of the third transistor (t3) and a first inverter (i1) in the case of the subtracter (s), and through the channel of a fourth transistor (t4) to ground in the case of the adder (ad) or to the supply voltage (u) in the case of the subtracter (s);

— the second input of the second AND element (12) is connected to the output of the second complex gate (2), which output is coupled through the channel of a fifth transistor (t5), a second inverter (i2), and the channel of a sixth transistor (t6) — in this order — to the second input of the fourth AND element (24) and to the third inputs of the first AND element (11) and the first OR element (15), which three inputs are grounded through the channel of a seventh transistor (t7);

— the output of the first complex gate (1) is coupled through the channel of an eighth transistor (t8) and a third inverter (i3) — in this order — to the output (ag) of the adder (ad) or the subtracter (s), and

— the second two-phase clock signal (ts2) is applied to the gates of the fifth and eighth transistors (t5, t8), the filter sampling signal (fa) is applied to the gates of the second, fourth, and seventh transistors (t2, t4, t7), and a data shift signal (fs) is applied to the gates of the first, third, and sixth transistors (t1, t3, t6).

4. A circuit arrangement as claimed in claim 2 for a stage of the parallel-to-serial converter (pw) or the serial-to-parallel converter (sw), the digit complementer (se), and the status register (z), characterized by the following features:

— a one-bit delay stage is provided in which the channel of a ninth transistor (t9), a fourth inverter (i4), the channel of a tenth transistor (t10), and a fifth inverter (i5) are inserted in this order between the serial input (es, e) and the serial output (as);

— the input of the fourth inverter (i4) is connected through the channel of an eleventh transistor (t11) to the parallel input (ep) in the case of the converters (pw, sw) and to ground in the case of the digit complementer (se), while

— in the case of the status register (z), the input of the fourth inverter (i4) is connected through the channel of a twelfth transistor (t12) to the output (as), and

— the data shift signal (fs) is applied to the gate of the ninth transistor (t9), the second two-phase clock signal (ts2) is applied to the gate of the tenth transistor (t10), the filter sampling signal (fa) is applied to the gate of the eleventh transistor (t11), and a data hold signal (fh) is applied to the gate of the twelfth transistor (t12).

5. A circuit arrangement as claimed in claim 2 for the sign-signal repeater (vw), characterized by the following features:

— the channel of a first input transistor (et1) and a one-bit delay stage consisting of the channel of a ninth transistor (t9), a fourth inverter (i4), the channel of a tenth transistor (t10), and a fifth inverter (i5) are inserted in this order between the input (e) and the output (ag);

— the node of the first input transistor (et1) and the ninth transistor (t9) is connected to the output (ag) through the channel of a thirteenth transistor (t13);

— a sign repeat signal (fw) is applied to the gate of the thirteenth transistor (t13) and, through a sixth inverter (i6), to the gate of the first input transistor (et1), and

— the data shift signal (fs) is applied to the gate of the ninth transistor (t9), and the second two-phase clock signal (ts2) is applied to the gate of the tenth transistor (t10).

6. A circuit arrangement as claimed in claim 5, characterized by the following features:

— additional input transistors (etn) are provided whose channels are connected between the ninth transistor (t9) and one stage output of the status register (z) each;

— the sixth inverter (i6) is replaced with a first, two-input NOR gate (n1);

— each further input transistor (etn) has one further two-input NOR gate (nn) associated with it which drives the gate of the input transistor, and

— the sign repeat signal (fw) is applied to the first inputs of the NOR gates (n1 . . . nn), and one of n filter constant selection signals (fk1 . . . fkn) is applied to the second inputs of the NOR gates (n1 . . . nn).

## Revendications

1. Montage de circuit pour filtres numériques qui sont chargés de traiter en série des données numériques d'entrée, en code binaire naturel et en représentation par complément à deux, pendant de brèves impulsions d'un signal d'échantillonnage de filtre (fa) et qui renferment, côté entrée, un convertisseur parallèle-série (pw), au moins au additionneur (ad), au moins un registre de décalage tenant lieu de mémoire d'état (z), au moins un multiplicateur (m1 . . .) sur lequel est dirigé un signal dépendant des données d'entrée tenant lieu de multiplicateur et un facteur — constant, tout au moins pendant la multiplication — tenant lieu de multiplicande, et, côté sortie, un convertisseur série-parallèle (sw), caractérisé en ce que:

— en plus du nombre d'étages déterminé par le nombre de chiffres des données d'entrée, la mémoire d'état (z) comporte d'autres étages dont le nombre est égal au nombre de chiffre du multiplicande,

— en aval du convertisseur parallèle-série (pw) est prévu un compléteur (se) chargé d'amener le nombre de chiffres du signal de sortie du convertisseur parallèle-série (pw) au niveau de celui de la mémoire d'état (z),

— la fonction du multiplicateur (m1 . . .) est réalisée sur au moins un étage (r) de la mémoire d'état (z) par un répéteur de signal de signe (vw) et par un point de prélèvement relié à l'entrée dudit répéteur,

— selon le type de filtre,
— —les deux entrée d'un soustracteur (s) sont reliées à la sortie du compléteur (se) et à la sortie série de la mémoire d'état (z), les deux entrées de l'additionneur (ad), à la sortie du répéteur de signal de signe (vw) et à la sortie du soustracteur (s), et la sortie de l'additionneur (ad) à l'entree du convertisseur série-parallèle (sw) ou d'une autre mémoire supplémentaire (z2 . . .)
— —ou bien les deux entrées de l'additionneur (ad) sont reliées à la sortie du compléteur (se) et à la sortie série de la mémoire d'état (z), les deux entrées du soustracteur (s), à la sortie du répéteur de signal de signe (vw) et à la sortie de l'additionneur (ad), et la sortie du soustracteur (s) à l'entrée du convertisseur série-parallèle (sw) ou d'une autre mémoire supplémentaire (z2 . . .).

2. Montage de circuits conforme à la revendication 1, caractérisé en ce qu'il est réalisé sous forme intégrée selon la technique des transistors à effet de champ dynamique biphasés.

3. Montage de circuits conforme à la revendication 2 pour additionneur (ad) et soustracteur (s), caractérisé en ce que:

— une première porte complexe (1) se compose d'un premier élément logique ET (11) à trois entrées, d'un premier élément logique OU (15) à trois entrées, d'un second élément logique ET (12) à deux entrées et d'un premier élément logique OU-NON (16) à deux entrées, les sorties des éléments logiques ET (11, 12) étant reliées chacune à une entrée du premier élément logique OU-NON (16) et la sortie du premier élément logique OU (15) étant relié à la première entrée du second élément logique ET (12),

— une seconde porte complexe (2) se compose d'un troisième élément logique ET (23) à deux entrées, d'un second élément logique OU (25) à deux entrées, d'un quatrième élément logique ET (24) à deux entrées et d'un second élément logique OU-NON (26) à deux entrées, les sorties des éléments logiques ET (23, 24) étant reliées chacune à une entrée du second élément logique OU-NON (26) et la sortie du second élément logique OU (25) étant reliée à la première entrée du quatrième élément logique ET (24),

— la première entrée du premier et du troisième élément logique ET (11, 23) ainsi que du premier et du second élément logique OU (15, 25) est reliée par le trajet de conduction d'un premier transistor (t1) à la première entrée de signaux (a) et par le trajet de conduction d'un second transistor (t2) au point zéro du circuit, dans le cas d'un additionneur (ad), ou à la tension de service (u), dans le cas d'un soustracteur (s),

— la seconde entrée du premier et du troisième élément logique ET (11, 23) ainsi que du premier et du deuxième élément logique OU (15, 25) est reliée par le trajet de conduction d'un troisième transistor (t3) directement à une seconde entrée de signaux (b), dans le cas d'un additionneur (ad), ou à l'entrée de terme à soustraire (b') dans le cas d'un soustracteur (s) — — à condition d'y intercaler un premier inverseur (i1) — — et par le trajet de conduction d'un quatrième transistor (t4) au point zéro du circuit, dans le cas d'un additionneur (ad), ou à la tension de service (u), dans le cas d'un soustracteur (s),

— la seconde entrée du second élément logique ET (12) est reliée à la sortie de la seconde porte complexe (2) laquelle est reliée par, dans l'ordre, le trajet de conduction d'un cinquième transistor (t5), un second inverseur (i2) et le trajet de conduction d'un sixième transistor (t6) à la seconde entrée du quatrième élément ET (24) et à la troisième entrée du premier élément ET (11) et du premier élément OU (15), lesdites trois entrées étant reliées au point zéro du circuit par le trajet de conduction d'un septième transistor (t7),

— la sortie de la première porte complexe (1) est reliée, dans cet ordre, par le trajet de conduction d'un huitième transistor (t8) et d'un troisième inverseur (i3) à la sortie (ag) de l'additionneur (ad) ou du soustracteur (s),

— les grilles du cinquième et du huitième transistor (t5, t8) reçoivent le second signal de synchronisation biphasé (ts2), les grilles du second, du quatrième et du septième transistor (t2, t4, t7) le signal d'échantillonnage de filtre (fa) et les grilles du premier, troisième et du sixième transistor (t1, t3, t6) un signal de décalage de données (fs).

4. Montage de circuits conforme à la revendication 2 pour un étage du convertisseur parallèle-série (pw) ou du convertisseur série-parallèle (sw), ou du compléteur (se) , ou de la mémoire d'état (z), caractérisé en ce que:

— il est prévu un étage de retard à un seul bit dans lequel sont reliés, dans cet ordre, entre l'entrée (e ou es) et la sortie série (as), le trajet de conduction d'un neuvième transistor (t9), un quatrième inverseur (i4), le trajet de conduction d'un dixième transistor (t10) et un cinquième inverseur (i5),

— dans le cas des convertisseurs (tw, sw) ou du compléteur (se), l'entrée du quatrième inverseur (i4) est reliée par le trajet de conduction d'un onzième transistor (t11) à l'entrée parallèle (e) des convertisseurs (pw, sw) ou au point zéro du circuit, ou

— dans le cas de la mémoire d'état (z), l'entrée du quatrième inverseur (i4) est reliée par le trajet de conduction d'un douzième transistor (t12) à la sortie (as), et

— la porte du neuvième transistor (t9) est reliée au signal de décalage des données (fs), la porte du dixième transistor (t10) au second signal de synchronisation biphasé (ts2), la porte du onsième transistor (t11) au signal d'échantillonnage de filtre (fa) et la porte du douzième transistor (t12) à un signal de maintien de données (fh).

5. Montage de circuits conforme à la revendication 2 pour le répéteur de signal de signe (vw), caractérisé en ce que:

— entre l'entrée (e) et la sortie (ag) sont prévus, dans cet ordre, le trajet de conduction d'un premier transistor d'entrée (et1) et un premier étage de retard à un seul bit, dans lequel sont reliés, dans cet ordre, entre le premier transistor d'entrée (et1) et la sortie série (as), le trajet de conduction d'un neuvième transistor (t9), un quatrième inverseur (i4), l'itinéraire de connexion d'un dixième transistor (t10) et un cinquième inverseur (i5),

— le point de liaison du premier transistor d'entrée (et1) et du neuvième transistor (t9) est relié à la sortie (ag) par le trajet de conduction d'un treizième transistor (t13),

— la grille du treizième transistor (t13) reçoit un signal de répétition de signe (fw) et la grille du premier transistor d'entrée (et1) reçoit ce signal par un sixième inverseur (i6),

— le signal de décalage de données (fs) est appliqué à la grille du neuvième transistor (t9) et le deuxième signal de synchronisation biphasé (ts2) est appliqué à la porte du dixième transistor (t10).

6. Montage de circuits conforme à la revendication 5, caractérisé en ce que:

— il est prévu d'autres transistors d'entrée (etn) dont les trajets de conduction sont placés entre le neuvième transistor (t9) et la sortie d'un autre étage de la mémoire supplémentaire (z),

— le sixième inverseur (i6) est remplacé par une première porte OU-NON (n1) à deux entrées,

— une porte supplémentaire OU-NON (nn) à deux entrées est affectée à chaque transistor d'entrée supplémentaire (etn), commandant la grille dudit transistor supplémentaire,

— la première entrée de la porte OU-NON (n1 ... nn) reçoit le signal de répétition de signe (fw) et la seconde entrée de la porte OU-NON (n1 ... nn) reçoit un des n signaux de sélection de constante du filtre (fk1 ... fkn).

0 090 904

FIG.1

FIG. 2

13

FIG. 3

FIG. 4

b3

ep

t 11    fa

t 9    t 10    i5

es    as

fs    i4    ts2

**FIG. 5**

b4

fh

t 12

t 9    t 10

e    as

i4    i5

fs    ts2

**FIG. 6**

b5

t 11    fa

t 9    t 10    i5

e    as

i4

fs    ts2    **FIG. 7**

b6

i5

et 1    t 9    t 10

e    ag

i4

fs    ts 2

i 6

t 13

**FIG. 8**

fw

FIG. 9

FIG. 10

FIG. 11 a)

b)

| | m1 | m2 | m3 | m4 | |
|---|---|---|---|---|---|
| Option I | $1-2^{-1}$ | $1-2^{-2}$ | $1-2^{-10}$ | $2^{-4}$ | fw1, fw2, fw3; fk1 |
| Option II | $1-2^{-2}$ | $1-2^{-3}$ | $1-2^{-9}$ | $2^{-5}$ | fw1', fw2', fw3'; fk2 |

c)

0 090 904

FIG. 12